# EUROPÄISCHE PATENTANMELDUNG

(11) **EP 4 657 102 A1**
(43) Veröffentlichungstag der Anmeldung: **03.12.2025**
(21) Anmeldenummer: 25171966.2
(22) Anmeldetag: 23.04.2025
(51) Int. Cl.: G01R 31/52, B61L 27/53

(54) **TESTEINRICHTUNGEN, INSBESONDERE FÜR EISENBAHNANLAGEN, SOWIE STEUERGERÄTE UND EISENBAHNANLAGEN MIT SOLCHEN TESTEINRICHTUNGEN**

(30) Priorität: 28.05.2024 DE 102024204925
(71) Anmelder: Siemens Mobility GmbH, 80997 München (DE)
(72) Erfinder: Pinkert, Tjeerd, 38118 Braunschweig (DE)
(74) Vertreter: Siemens Patent Attorneys

(57) **Zusammenfassung**

Die Erfindung bezieht sich unter anderem auf eine Testeinrichtung. Erfindungsgemäß ist vorgesehen, dass die Testeinrichtung (TE1, TE2, TE101-TE104, TE201-TE202) umfasst: eine erste Einspeiseeinrichtung (E1v, E1f) zum Anlegen eines ersten kodierten Testsignals (T1v, T1f) zwischen einem ersten Anschluss (A1v, A1f) und einem Referenzanschluss, eine erste Messeinrichtung (M1v, M1f), die zum Messen eines ersten Messsignals (MS1v, MS1f) geeignet ist, das durch das erste kodierte Testsignal zumindest mithervorgerufen und von einem etwaigen Erdschluss einer an den ersten Anschluss angeschlossenen Anschlussleitung beeinflusst wird, und eine erste Auswerteinrichtung (AUS1v, AUS1f), die das erste Messsignal und das Testsignal einer ersten Korrelationsprüfung unter Bildung eines ersten Korrelationssignals unterwirft und im Falle einer Veränderung der Amplitude des ersten Korrelationssignals über ein vorgegebenes korrelationsbezogenes Maß hinaus auf einen Erdschluss schließt und ein das erste kodierte Testsignal betreffendes erstes Fehlersignal (F1v, F1f) erzeugt.

## Beschreibung

Die Erfindung bezieht sich auf Testeinrichtungen, Steuergeräte zum Ansteuern von Feldgeräten elektrotechnischer Anlagen und Eisenbahnanlagen mit solchen Testeinrichtungen und/oder Steuergeräten.

Der Erfindung liegt die Aufgabe zugrunde, eine Testeinrichtung anzugeben, die zum Erkennen von Erdfehlern im Bereich der Eisenbahntechnik besonders geeignet ist.

Diese Aufgabe wird durch eine Testeinrichtung mit den Merkmalen gemäß Patentanspruch 1 gelöst. Vorteilhafte Ausgestaltungen der erfindungsgemäßen Testeinrichtung sind in Unteransprüchen angegeben.

Danach ist erfindungsgemäß vorgesehen, dass die Testeinrichtung umfasst: eine erste Einspeiseeinrichtung zum Anlegen eines ersten kodierten Testsignals zwischen einem ersten Anschluss und einem Referenzanschluss, eine erste Messeinrichtung, die zum Messen eines ersten Messsignals geeignet ist, das durch das erste kodierte Testsignal zumindest mithervorgerufen und von einem etwaigen Erdschluss einer an den ersten Anschluss angeschlossenen Anschlussleitung beeinflusst wird, und eine erste Auswerteinrichtung, die das erste Messsignal und das Testsignal einer ersten Korrelationsprüfung unter Bildung eines ersten Korrelationssignals unterwirft und im Falle einer Veränderung der Amplitude des ersten Korrelationssignals über ein vorgegebenes korrelationsbezogenes Maß hinaus auf einen Erdschluss schließt und ein das erste kodierte Testsignal betreffendes erstes Fehlersignal erzeugt.

Ein wesentlicher Vorteil der erfindungsgemäßen Testeinrichtung ist darin zu sehen, dass die Korrelationsprüfung eine sehr zuverlässige Erdschlusserkennung ermöglicht, weil Messfehler durch Störsignale bei der Erdschlussprüfung im Rahmen der Korrelationsprüfung quasi ausgeblendet werden können.

Um zu ermöglichen, dass die Testeinrichtung zeitgleich zumindest auch eine zweite Erdschlussprüfung bezüglich einer anderen Leitung bzw. einem anderen Anschluss durchführen kann, wird es als vorteilhaft angesehen, wenn die Testeinrichtung außerdem umfasst: eine zweite Einspeiseeinrichtung zum Anlegen eines zweiten kodierten Testsignals zwischen einem zweiten Anschluss und dem Referenzanschluss, wobei das erste und das zweite kodierte Testsignal zueinander orthogonal sind, eine zweite Messeinrichtung zum Messen eines zweiten Messsignals, das durch das zweite kodierte Testsignal zumindest mithervorgerufen wird, und eine zweite Auswerteinrichtung, die das zweite Messsignal und das zweite Testsignal einer zweiten Korrelationsprüfung unter Bildung eines zweiten Korrelationssignals unterzieht und im Falle einer Veränderung der Amplitude des zweiten Korrelationssignals über das oder ein anderes vorgegebenes korrelationsbezogenes Maß hinaus auf einen Erdschluss schließt und ein das zweite kodierte Testsignal betreffendes Fehlersignal erzeugt. Durch die Orthogonalität der beiden Testsignale ist ein störungsfreier Parallelbetrieb zweier Tests möglich.

Signale werden vorzugsweise als orthogonal angesehen, wenn die mathematisch errechnete Korrelation zwischen den Signalen Null beträgt oder zumindest im Rahmen der Messgenauigkeit quasi Null ist oder zumindest eine vorgegebene Korrelationsschwelle unterschreitet.

Besonders vorteilhaft ist es, wenn die Testeinrichtung umfasst: eine oder mehr weitere Einspeiseeinrichtungen zum Anlegen jeweils eines weiteren kodierten Testsignals zwischen einem zugeordneten weiteren Anschluss und dem Referenzanschluss, wobei die kodierten Testspannungssignale zueinander orthogonal sind, für jede weitere Einspeiseeinrichtung jeweils eine weitere Messeinrichtung zum Messen jeweils eines weiteren Messsignals, das durch das jeweilige weitere kodierte Testsignal zumindest mithervorgerufen wird, und für jede weitere Einspeiseeinrichtung jeweils eine weitere Auswerteinrichtung, die das jeweilige weitere Messsignal und das jeweilige weitere Testsignal einer weiteren Korrelationsprüfung unter Bildung eines weiteren Korrelationssignals unterzieht und im Falle einer Veränderung der Amplitude des weiteren Korrelationssignals über das oder ein anderes vorgegebenes korrelationsbezogenes Maß hinaus auf einen Erdschluss schließt und ein das weitere kodierte Testsignal betreffendes Fehlersignal erzeugt.

Bezüglich der Ausgestaltung der Auswerteinrichtungen wird es als vorteilhaft angesehen, wenn diese anhand der Amplitude und/oder Phasenlage des jeweiligen Korrelationssignals den Abstand eines Erdschlusses von dem Ort der Testeinrichtung ermittelt.

Bei einer Art Testeinrichtung ist vorgesehen, dass der Referenzanschluss an das Erdpotential angeschlossen ist und das erste Messsignal ein erster Messstrom ist, der zwischen dem ersten Anschluss und dem Erdpotential fließt, oder eine erste Messspannung ist, die der zwischen dem ersten Anschluss und dem Erdpotential liegenden Spannung entspricht oder proportional zu dieser ist.

Die Erfindung bezieht sich außerdem auf ein Steuergerät zum Ansteuern zumindest eines Feldgeräts einer elektrotechnischen Anlage. Erfindungsgemäß ist diesbezüglich vorgesehen, dass das Steuergerät mindestens eine Testeinrichtung wie oben beschrieben umfasst.

Das Steuergerät ist vorzugsweise ein eisenbahntechnisches Steuergerät zum Steuern einer oder mehr eisenbahntechnischer Feldgeräte, insbesondere einer Weiche oder eines Signals, einer Eisenbahnanlage.

Das Steuergerät umfasst auf einer Feldgeräteseite vorzugsweise eine Testeinrichtung, bei der der erste Anschluss ein erster Anschlusskontakt des Steuergeräts zum Übermitteln einer Steuerspannung an ein erstes Feldgerät ist und der Referenzanschluss mit einem geräteinternen Massepotential verbunden ist, das an das Erdpotential hochohmig gekoppelt ist.

Bei der letztgenannten Ausgestaltung ist es von Vorteil, wenn der erste Anschlusskontakt zu einem ersten Anschlusspaar gehört und zum Anschluss eines das Steuergerät und das Feldgerät verbindenden ersten Leiters eines ersten Leiterpaares dient, das Steuergerät einen zu dem ersten Anschlusspaar gehörenden zweiten Anschlusskontakt zum Anschluss eines das Steuergerät und das Feldgerät verbindenden zweiten Leiters umfasst, das erste kodierte Testsignal zwischen dem ersten Anschlusskontakt und dem Massepotential anliegt und das erste Messsignal ein erster Messstrom ist, der zwischen dem zweiten Anschlusskontakt und dem Massepotential fließt, oder eine erste Messspannung ist, die der zwischen dem zweiten Anschlusskontakt und dem Massepotential liegenden Spannung entspricht oder proportional zu dieser ist.

Auch ist es vorteilhaft, wenn das Steuergerät auf einer Energieversorgungsseite eine Testeinrichtung umfasst, bei der der erste Anschluss der Testeinrichtung ein erster Energieversorgungsanschluss des Feldgeräts zum Einspeisen einer ersten externen Energieversorgungsspannung in das Feldgerät ist.

Die Erfindung bezieht sich außerdem auf eine Eisenbahnanlage mit zumindest einer Testeinrichtung wie oben beschrieben.

Besonders vorteilhaft ist es, wenn die Eisenbahnanlage mit zumindest zwei Testeinrichtungen ausgestattet ist, bei denen die ersten Einspeiseeinrichtungen der zumindest zwei Testeinrichtungen jeweils ein erstes kodiertes Testsignal in dieselbe Leitung der Eisenbahnanlage einspeisen, die ersten Messeinrichtungen jeweils ein erstes Messsignal messen, das durch ihr jeweiliges erstes kodiertes Testsignal zumindest mithervorgerufen und von einem etwaigen Erdschluss einer an den ersten Anschluss angeschlossenen Leitung beeinflusst wird, und die ersten Auswerteinrichtungen jeweils das erste Messsignal ihrer eigenen Testeinrichtung und das Testsignal ihrer eigenen Testeinrichtung einer ersten Korrelationsprüfung unter Bildung eines ersten Korrelationssignals unterwerfen und im Falle einer Veränderung der Amplitude des ersten Korrelationssignals über das vorgegebene korrelationsbezogene Maß hinaus auf einen Erdschluss schließen und ein ihr erstes kodiertes Testsignal betreffendes erstes Fehlersignal erzeugen, wobei die ersten kodierten Testspannungssignale der zumindest zwei Testeinrichtungen orthogonal zueinander sind.

Auch kann in vorteilhafter Weise eine Kreuzkorrelationsprüfung vorgesehen sein. Beispielsweise ist es vorteilhaft, wenn den zumindest zwei Testeinrichtungen jeweils die eigene Kodierung zur Bildung des jeweiligen eigenen kodierten ersten Testsignals sowie die Kodierungen, die die anderen Testeinrichtungen zur Bildung der kodierten ersten Testsignale heranziehen, bekannt sind, und die ersten Auswerteinrichtungen der zumindest zwei Testeinrichtungen jeweils für jedes Paar an Testeinrichtungen, das die eigene Testeinrichtung und eine beliebige andere der zumindest zwei Testeinrichtungen enthält, jeweils eine erste paarbezogene Kreuzkorrelationsprüfung durchführen, wobei sie im Rahmen der Kreuzkorrelationsprüfung jeweils mit der bekannten Kodierung der anderen Testeinrichtung des jeweiligen Paares ein erstes Kreuzreferenzsignal bilden, das dem von der anderen Testeinrichtung erzeugten ersten Testsignal kodierungsmäßig entspricht, und das erste Messsignal ihrer eigenen Testeinrichtung und das jeweilige erste Kreuzreferenzsignal einer ersten Kreuzkorrelationsberechnung unter Bildung eines ersten Kreuzkorrelationssignals unterwerfen, wobei sie jeweils im Falle einer Veränderung der Amplitude des ersten Kreuzkorrelationssignals über ein vorgegebenes kreuzkorrelationsbezogenes Maß hinaus auf einen Erdschluss schließen und ein entsprechendes Fehlersignal erzeugen.

Besonders vorteilhaft ist es, wen die Eisenbahnanlage eine Ortungseinrichtung umfasst, die anhand von Abstandswerten der Testeinrichtungen den Ort eines Erdschlusses ermittelt.

Die Eisenbahnanlage ist vorzugsweise mit zumindest einem Steuergerät wie oben beschrieben ausgestattet, das an seiner Feldgeräteseite an zumindest ein Feldgerät der Eisenbahnanlage und an seiner Energieversorgungsseite an ein Energieversorgungsnetz der Eisenbahnanlage angeschlossen ist. Das zumindest eine Feldgerät ist vorzugsweise eine Weiche oder ein Eisenbahnsignal.

Die Erfindung wird nachfolgend anhand von Ausführungsbeispielen näher erläutert; dabei zeigen beispielhaft:
- Fig. 1-3: ein Ausführungsbeispiel für ein erfindungsgemäßes Steuergerät, das mit zwei Ausführungsbeispielen für erfindungsgemäße Testeinrichtungen ausgestattet ist, und
- Fig. 4: ein Ausführungsbeispiel für eine erfindungsgemäßes Eisenbahnanlage, die unter anderem mit dem Steuergerät gemäß den Figuren 1 bis 3 sowie weiteren Testeinrichtungen ausgestattet ist.

In den Figuren werden der Übersicht halber für identische oder vergleichbare Komponenten stets dieselben Bezugszeichen verwendet.

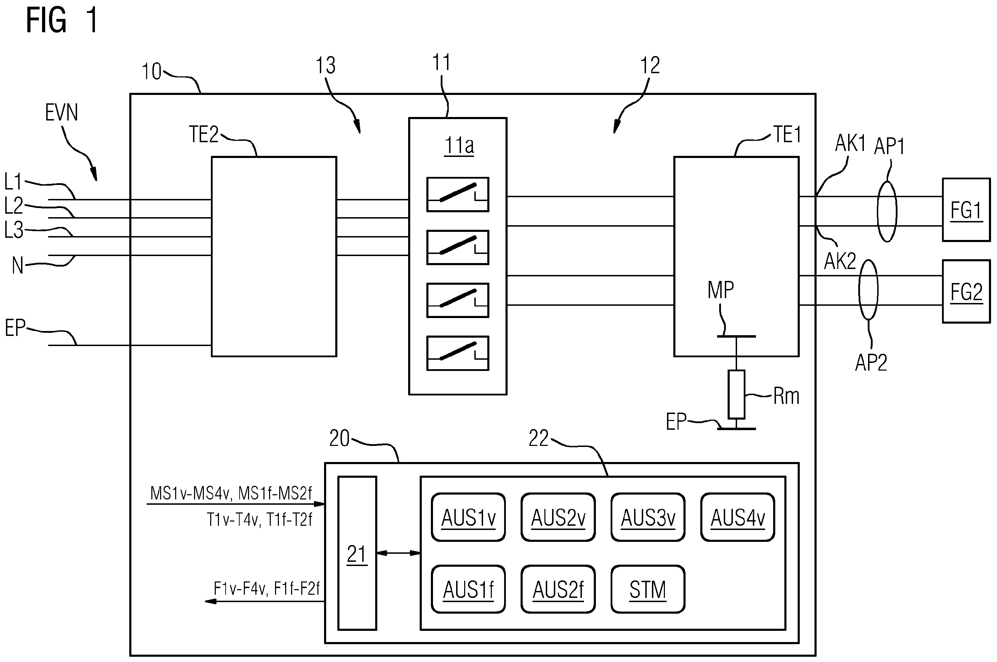

Die Figur 1 zeigt ein Ausführungsbeispiel für ein erfindungsgemäßes Steuergerät 10. Das Steuergerät 10 umfasst eine interne Schaltanordnung 11, die eine Feldgeräteseite 12 des Steuergeräts 10 mit einer Energieversorgungsseite 13 des Steuergeräts 10 verbindet. Die interne Schaltanordnung 11 umfasst eine Vielzahl an Schalteinrichtungen 11a, die das Einstellen einer gewünschten elektrischen Verschaltung von Leitern auf der Energieversorgungsseite 13 mit Leitern auf der Feldgeräteseite 12 ermöglichen. Vorteilhaft ist es, wenn die Schalteinrichtungen 11a der Schaltanordnung 11 durch entsprechende Schalterstellung jeden an der Energieversorgungsseite 13 des Steuergeräts 10 angeschlossenen Leiter jeweils wahlweise mit jedem an der Feldgeräteseite 12 des Steuergeräts 10 angeschlossenen Leiter verbinden können.

Auf der Feldgeräteseite 12 sind ein erstes Anschlusspaar AP1 zum Anschluss an ein erstes Feldgerät FG1 und ein zweites Anschlusspaar AP2 zum Anschluss an ein zweites Feldgerät FG2 vorhanden. Zum Anschluss des ersten Feldgeräts FG1 ist das erste Anschlusspaar AP1 mit einem ersten Anschlusskontakt AK1 und mit einem zweiten Anschlusskontakt AK2 des Steuergeräts 10 verbunden.

An der Energieversorgungsseite 13 des Steuergeräts 10 ist ein im fehlerfreien Falle vom Erdpotential EP getrenntes Energieversorgungsnetz EVN mit einem ersten Phasenleiter L1, einem zweiten Phasenleiter L2, einem dritten Phasenleiter L3 und einem Nullleiter N angeschlossen. Außerdem steht das Steuergerät 10 mit dem erwähnten Erdpotential EP in Verbindung.

Auf der Feldgeräteseite 12 ist das Steuergerät 10 mit einer Testeinrichtung TE1 erster Art und auf der Energieversorgungsseite 13 mit einer Testeinrichtung TE2 zweiter Art ausgestattet. Beide Testeinrichtungen stehen mit dem Erdpotential EP in Verbindung, sei es über eine hochohmige Ankopplung mittels eines hochohmigen Widerstands Rm (Rm beträgt zum Beispiel 1 MΩ) (siehe Testeinrichtung TE1 erster Art) oder unmittelbar (siehe Testeinrichtung TE2 zweiter Art).

Das Steuergerät 10 ist außerdem mit einer Zentraleinrichtung 20 ausgestattet, die eine programmierbare Recheneinrichtung 21, vorzugsweise einen programmierten Computer, und einen Speicher 22 zum Speichern von Programmmodulen oder sonstigen Steuerdaten umfassen kann. Die Zentraleinrichtung 20 kann zum Steuern der internen Schaltanordnung 11 mittels eines Steuermoduls STM dienen sowie weitere Aufgaben übernehmen, beispielsweise die Aufgabe, die Funktion von Auswerteinrichtungen für die Testeinrichtungen TE1 und TE2 wahrzunehmen.

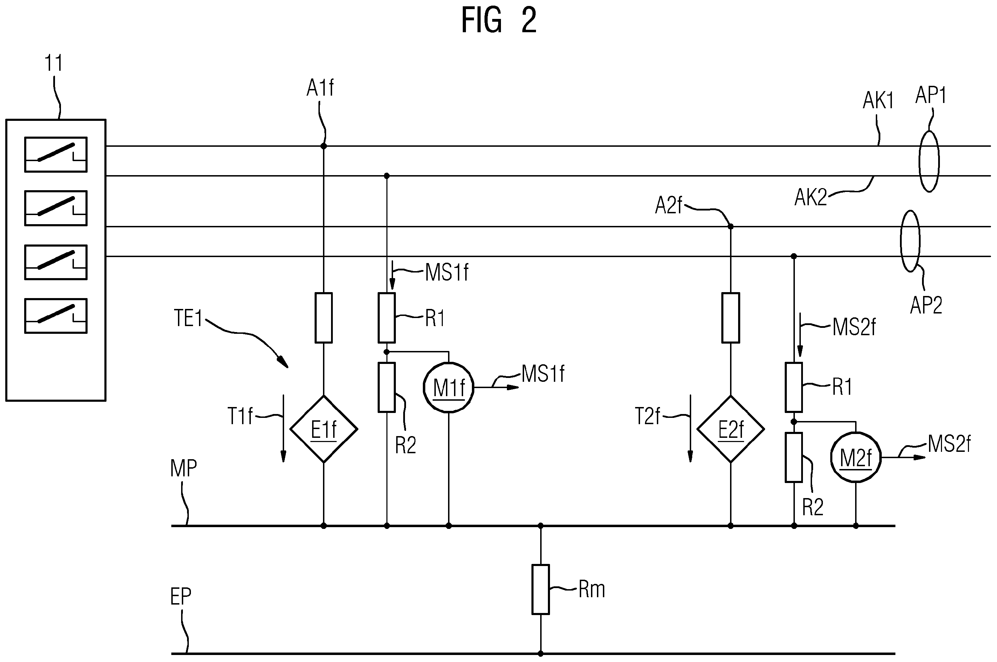

Die Figur 2 zeigt die Feldgeräteseite 12 und damit die auf der Feldgeräteseite 12 angeordnete Testeinrichtung TE1 erster Art näher im Detail.

Die Testeinrichtung TE1 umfasst eine erste Einspeiseeinrichtung E1f zum Einspeisen eines Testsignals, beispielsweise durch Anlegen eines ersten kodierten Testspannungssignals T1f zwischen einem ersten Anschluss A1f der Testeinrichtung TE1, der mit dem ersten Anschlusskontakt AK1 des Steuergeräts 10 verbunden ist, und einem Referenzanschluss, der durch ein internes Massepotential MP der Testeinrichtung TE1 und des Steuergeräts 10 gebildet wird. Das Massepotential MP steht über den hochohmigen Widerstand Rm mit dem Erdpotential EP in Verbindung.

Die Testeinrichtung TE1 umfasst außerdem eine erste Messeinrichtung M1f, die zum Messen eines ersten Messsignals MS1f geeignet ist, das durch das erste kodierte Testspannungssignal T1f hervorgerufen und von einem etwaigen Erdschluss der Anschlussleitungen des ersten Anschlusspaars AP1 beeinflusst wird. Bei der Testeinrichtung TE1 gemäß Figur 2 wird das erste Messsignal MS1f durch einen ersten Messstrom gebildet, der über den zweiten Anschlusskontakt AK2 zu dem Massepotential MP fließt und vorzugsweise mittels eines durch zwei Widerstände R1 (R1 z. B. 100k Ω) und R2 (R2 zum Beispiel 50 kΩ) gebildeten Spannungsteilers und einer als Spannungsmesseinrichtung ausgebildeten Messeinrichtung M1f gemessen wird.

Die Testeinrichtung TE1 umfasst außerdem eine erste Auswerteinrichtung AUSf1, die bei dem Ausführungsbeispiel gemäß Figur 2 in Form eines Softwaremoduls ausgestaltet und in dem Speicher 22 der Zentraleinrichtung 20 (siehe Figur 1) abgespeichert ist und durch die Recheneinrichtung 21 der Zentraleinrichtung 20 ausgeführt wird.

Die erste Auswerteinrichtung AUSf1 unterwirft das erste Messsignal MS1f und das Testspannungssignal T1f einer ersten Korrelationsprüfung unter Bildung eines ersten Korrelationssignals und schließt im Falle einer Veränderung der Amplitude des ersten Korrelationssignals über ein vorgegebenes korrelationsbezogenes Maß hinaus auf einen Erdschluss und erzeugt ein das erste kodierte Testspannungssignal T1f betreffendes erstes Fehlersignal F1f.

Die Korrelationsprüfung basiert beispielsweise auf einer mathematischen Korrelationsberechnung digitaler Werte, die das erste Messsignal MS1f und das Testspannungssignal T1f beschreiben. Die Berechnung von Korrelationen zweier Signale mittels programmierter Computer ist allgemein bekannt, sodass diesbezüglich auf die Literatur, beispielsweise auch Wikipedia verwiesen sei.

Bei dem Ausführungsbeispiel gemäß Figur 2 ist die erste Auswerteinrichtung AUS1f in Form eines Softwaremoduls ausgestaltet, das in der Zentraleinrichtung 20 abgespeichert und ausgeführt wird; alternativ kann die Testeinrichtung TE1 (entsprechendes gilt für die Testeinrichtung TE2) eine eigene Recheneinrichtung aufweisen, um die Auswertung und Korrelationsprüfung autark vorzunehmen.

Die Feststellung, dass sich das erste Korrelationssignal über ein vorgegebenes korrelationsbezogenes Maß hinaus verändert hat, erfolgt beispielsweise dann, wenn das erste Korrelationssignal eine über ein vorgegebenes Maß kleinere Amplitude aufweist als eine vorgegebene Sollamplitude, die während eines erdfehlerfreien Zustands als Sollvorgabe erfasst und beispielweise in dem Speicher 22 abgespeichert worden ist.

Die Korrelationsprüfung mittels der ersten Einspeiseeinrichtung E1f, der ersten Messeinrichtung M1f und der ersten Auswerteinrichtung AUS1f bezieht sich also auf das erste Anschlusspaar AP1 und ermöglicht eine Erdschlusserkennung, sobald zumindest eine der beiden Anschlussleitungen des ersten Leiterpaares AP1 von einem Erdschluss betroffen ist.

Um auch eine Korrelationsprüfung bezüglich des zweiten Anschlusspaars AP2 durchführen zu können, ist die Testeinrichtung TE1 gemäß Figur 2 außerdem mit einer zweiten Einspeiseeinrichtung E2f, einer zweiten Messeinrichtung M2f und einer zweiten Auswerteinrichtung AUS2f (siehe Figur 1) ausgestattet.

Die zweite Einspeiseeinrichtung E2f dient zum Einspeisen eines zweiten kodierten Testsignals, und zwar durch Anlegen eines zweiten kodierten Testspannungssignals T2f zwischen einem zweiten Anschluss A2f der Testeinrichtung TE1 und dem Massepotential MP, wobei das erste und das zweite kodierte Testspannungssignal T1f und T2f zueinander orthogonal sind.

Die zweite Messeinrichtung M2f dient zum Messen eines zweiten Messsignals MS2f, das durch das zweite kodierte Testspannungssignal T2f hervorgerufen wird.

Die zweite Auswerteinrichtung AUS2f unterzieht das zweite Messsignal MS2f und das zweite Testspannungssignal T2f einer zweiten Korrelationsprüfung unter Bildung eines zweiten Korrelationssignals und schließt im Falle einer Veränderung der Amplitude des zweiten Korrelationssignals über das oder ein anderes vorgegebenes korrelationsbezogenes Maß hinaus auf einen Erdschluss und erzeugt ein das zweite kodierte Testspannungssignal T2f betreffendes Fehlersignal F2f.

Die zweite Auswerteinrichtung AUS2f ist vorzugsweise ebenfalls als Softwaremodul in der Zentraleinrichtung 20 integriert und unterzieht die das zweite Messsignal MS2f und das zweite Testspannungssignal T2f beschreibenden digitalen Messwerte einer mathematischen Korrelationsprüfung.

Die Erdschlussprüfung kann bezüglich der beiden Leitungspaare AP1 und AP2 individuell leitungspaarbezogen erfolgen, da die Testspannungsmesssignale T1f und T2f orthogonal zueinander sind.

Falls auf der Feldgeräteseite 12 noch weitere Leiterpaare zum Anschluss weiterer Feldgeräte vorhanden sind, so umfasst die Testeinrichtung TE1 vorzugsweise weitere Einspeiseeinrichtungen, weitere Messeinrichtungen und weitere Auswerteinrichtungen, für die die obigen Erläuterungen entsprechend gelten. Diese weiteren Einspeiseeinrichtungen, die weiteren Messeinrichtungen und die weiteren Auswerteinrichtungen sind der Übersicht halber in der Figur 2 nicht weiter gezeigt.

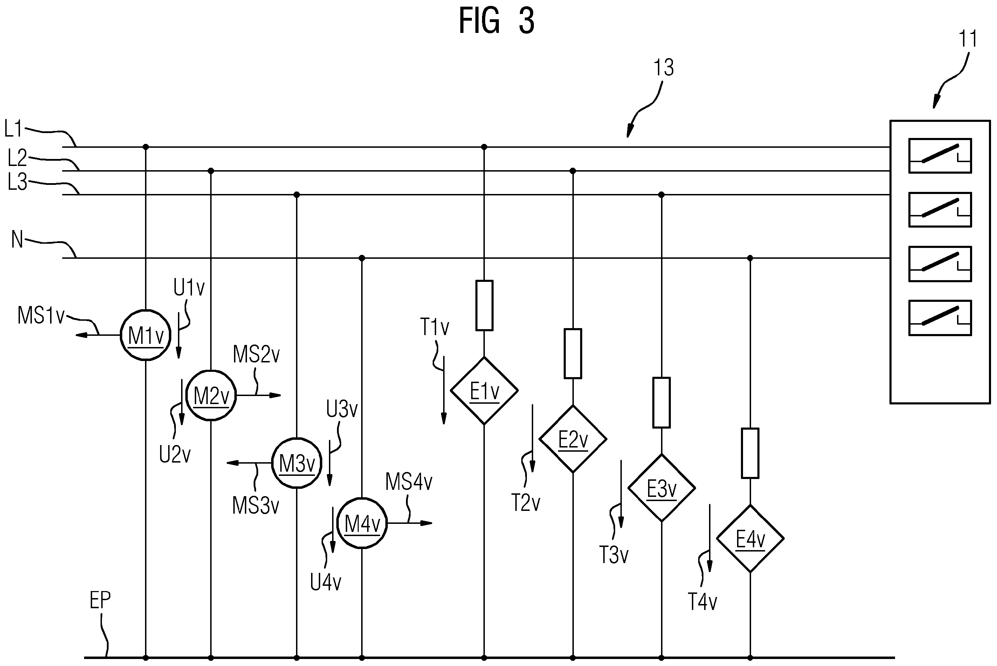

Die Figur 3 zeigt die Energieversorgungsseite 13 und damit die auf der Energieversorgungsseite 13 angeordnete Testeinrichtung TE2 zweiter Art näher im Detail.

Die Testeinrichtung TE2 zweiter Art umfasst eine erste Einspeiseeinrichtung E1v zum Anlegen eines ersten kodierten Testspannungssignals T1v zwischen einem ersten Anschluss A1v der Testeinrichtung TE2, der bei dem Ausführungsbeispiel an den ersten Phasenleiter L1 angeschlossen ist, und einem Referenzanschluss, der hier an das Erdpotential EP angeschlossen ist.

Das erste kodierte Testspannungssignal T1v der Testeinrichtung TE2 zweiter Art ist zu allen anderen Testsignalen orthogonal, insbesondere also zu dem ersten und zweiten kodierten Testspannungssignal T1f und T2f der Testeinrichtung TE1, um einen gleichzeitigen Betrieb der beiden Testeinrichtungen TE1 und TE2 zu erlauben.

Die Testeinrichtung TE2 zweiter Art umfasst außerdem eine erste Messeinrichtung M1v, die zum Messen eines ersten Messsignals MS1v geeignet ist, das durch das erste kodierte Testspannungssignal T1v hervorgerufen und von einem etwaigen Erdschluss des ersten Phasenleiters L1 beeinflusst wird. Bei der Testeinrichtung TE2 gemäß Figur 3 wird das erste Messsignal MS1v durch eine erste Messspannung U1v gebildet, die zwischen dem ersten Phasenleiter L1 und dem Erdpotential EP gemessen wird.

Die Testeinrichtung TE2 zweiter Art umfasst darüber hinaus eine erste Auswerteinrichtung AUS1v, die das erste Messsignal MS1v und das Testspannungssignal T1v einer ersten Korrelationsprüfung unter Bildung eines ersten Korrelationssignals unterwirft und im Falle einer Veränderung der Amplitude des ersten Korrelationssignals über ein vorgegebenes korrelationsbezogenes Maß hinaus auf einen Erdschluss schließt und ein das erste kodierte Testspannungssignal T1v betreffendes erstes Fehlersignal F1v erzeugt. Die Feststellung, dass sich das erste Korrelationssignal über ein vorgegebenes korrelationsbezogenes Maß hinaus verändert hat, erfolgt beispielsweise dann, wenn das erste Korrelationssignal eine über ein vorgegebenes Maß kleinere Amplitude aufweist als eine vorgegebene Sollamplitude, die während eines erdfehlerfreien Zustands als Sollvorgabe erfasst und abgespeichert worden ist.

Die erste Auswerteinrichtung AUS1v der Testeinrichtung TE2 zweiter Art ist vorzugsweise ebenfalls als Softwaremodul in der Zentraleinrichtung 20 integriert und unterzieht das erste Messsignal MS1v und das erste Testspannungssignal T1v beschreibende digitale Messwerte einer mathematischen Korrelationsprüfung.

Für die übrigen Phasenleiter L2 und L3 sowie für den Nullleiter N auf der Energieversorgungsseite kann die Testeinrichtung TE2 zweiter Art jeweils eine weitere Einspeiseeinrichtung E2v, E3v und E4v zum Anlegen jeweils eines weiteren kodierten Testspannungssignals T2v, T3v und T4v, jeweils eine weitere Messeinrichtung M2v, M3v und M4v zum Messen jeweils eines weiteren Messsignals MS2v, MS3v bzw. MS4v, das durch die jeweils korrespondierende weitere kodierte Testspannung hervorgerufen wird, und für jede weitere Einspeiseeinrichtung jeweils eine weitere Auswerteinrichtung AUS2v, AUS3v und AUS4v, die das jeweilige weitere Messsignal MS2v, MS3v bzw. MS4v und das jeweils korrespondierende Testspannungssignal T2v, T3v und T4v einer weiteren Korrelationsprüfung unter Bildung jeweils eines weiteren Korrelationssignals unterzieht und im Falle einer Veränderung der Amplitude des weiteren Korrelationssignals über das oder ein anderes vorgegebenes korrelationsbezogenes Maß hinaus auf einen Erdschluss schließt und ein das jeweilige weitere kodierte Testspannungssignal betreffendes Fehlersignal F2v, F3v bzw. F4v erzeugt.

Da alle Testspannungssignale untereinander jeweils orthogonal zueinander sind, können alle Tests beider Testeinrichtungen TE1 und TE2 zeitgleich durchgeführt werden, weil die Tests untereinander korrelationsfrei sind.

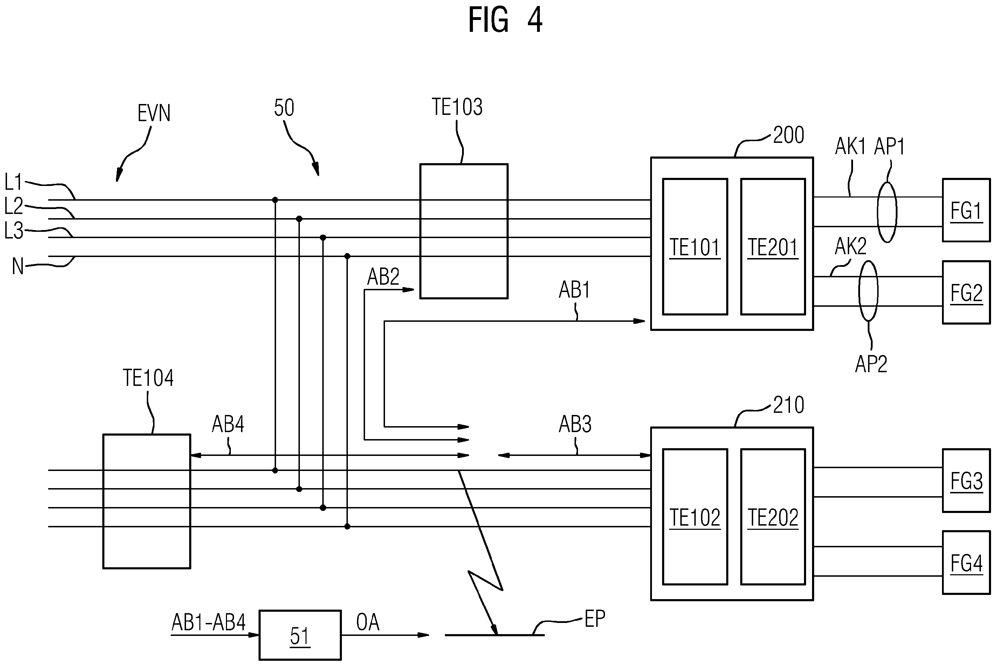

Die Figur 4 zeigt Bestandteile eines Ausführungsbeispiels für eine Eisenbahnanlage 50, von der vier Testeinrichtungen TE101 bis TE104 zweiter Art und zwei Testeinrichtungen TE201 und TE202 erster Art dargestellt sind.

Die Testeinrichtung TE101 zweiter Art und die Testeinrichtung T201 erster Art gehören zu einem Steuergerät 200, das mit dem Steuergerät 10 gemäß den Figuren 1 bis 3 identisch sein kann und an das die Feldgeräte FG1 und FG2 gemäß den Figuren 1 bis 3 angeschlossen sein können.

Die Testeinrichtung TE102 zweiter Art und die Testeinrichtung T202 erster Art gehören zu einem Steuergerät 210, das mit dem Steuergerät 10 gemäß den Figuren 1 bis 3 identisch sein kann und an das Feldgeräte FG3 und FG4 angeschlossen sein können.

Bei den Feldgeräten kann es sich um Weichen oder Eisenbahnsignale handeln.

Die Testeinrichtungen TE103 und TE104 zweiter Art sind autarke Testeinrichtungen, die mit den Testeinrichtungen zweiter Art des Steuergeräts 10 identisch sein können.

Die Testeinrichtungen TE101 bis TE104 zweiter Art sind jeweils mit einem ersten Anschluss an den ersten Phasenleiter L1 und mit ihrem Referenzanschluss an das Erdpotential EP angeschlossen und speisen jeweils ein erstes Testsignal in den ersten Phasenleiter L1 ein. Anhand erfasster Messignale erkennen sie jeweils einen Erdschluss in dem ersten Phasenleiter L1, wie dies oben im Zusammenhang mit den Figuren 1 bis 3 erläutert worden ist.

Darüber hinaus sind die Auswerteinrichtungen der Testeinrichtungen TE101 bis TE104 dazu ausgebildet, im Falle einer Veränderung des jeweiligen Korrelationssignals nicht nur ein Fehlersignal auszugeben, sondern außerdem einen Abstandswert AB1-AB4, der den Abstand zu dem erkannten Erdfehler angibt. Der Abstandswert wird dabei umso kleiner sein, je größer die Veränderung des jeweiligen Korrelationssignals ist, und umso größer, je kleiner die erfasste Veränderung des jeweiligen Korrelationssignals ist. Dieser Ansatz geht von dem Gedanken aus, dass sich nahe Erdfehler in den Messwerten deutlicher zeigen als ferne Erdfehler.

Die Abstandswerte AB1-AB4 werden zu einer Ortungseinrichtung 51 der Eisenbahnanlage übermittelt, die anhand der Abstandswerte AB1-AB4 die exakte Position des Erdfehlers unter Angabe einer Ortsangabe OA schätzen kann.

Auch können die Auswerteinrichtungen der Testeinrichtungen TE201 und TE202 erster Art dazu ausgebildet sein, im Falle einer Veränderung des jeweiligen Korrelationssignals nicht nur ein Fehlersignal auszugeben, sondern außerdem einen Abstandswert, der den Abstand zu dem erkannten Erdfehler angibt. In einem solchen Falle verarbeitet die Ortungseinrichtung 51 zur Fehlerortung vorzugsweise auch diese Abstandswerte.

Bei den obigen Ausführungsbeispielen kann auch vorgesehen sein, dass den Testeinrichtungen jeweils nicht nur die eigene Kodierung zur Bildung des jeweiligen eigenen kodierten ersten Testsignals sondern auch die Kodierungen, die die anderen Testeinrichtungen zur Bildung der kodierten ersten Testspannungssignale heranziehen, bekannt sind.

In einem solchen Falle können die Auswerteinrichtungen der Testeinrichtungen darüber hinaus paarweise eine Kreuzkorrelationsprüfung vornehmen, wobei sie im Rahmen der Kreuzkorrelationsprüfung jeweils mit der bekannten Kodierung einer anderen Testeinrichtung des jeweiligen Paares ein Kreuzreferenzsignal bilden, das dem von der anderen Testeinrichtung erzeugten ersten Testsignal kodierungsmäßig entspricht, und das erste Messsignal ihrer eigenen Testeinrichtung und das jeweilige erste Kreuzreferenzsignal einer ersten Kreuzkorrelationsberechnung unter Bildung eines ersten Kreuzkorrelationssignals unterwerfen, wobei sie jeweils im Falle einer Veränderung der Amplitude des ersten Kreuzkorrelationssignals über ein vorgegebenes kreuzkorrelationsbezogenes Maß hinaus auf einen Erdschluss schließen und ein entsprechendes Fehlersignal erzeugen und/oder den Abstand zu dem erkannten Fehler ermitteln, wie dies oben erläutert worden ist.

Die obigen Ausführungen gelten für eine Erdschlusserkennung bei den übrigen Phasenleitern L2-L3 und dem Nullleiter N des Energieversorgungsnetzes EVN entsprechend.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

### Bezugszeichenliste

- 10: Steuergerät
- 11: Schaltanordnung
- 11a: Schalteinrichtung
- 12: Feldgeräteseite
- 13: Energieversorgungsseite
- 20: Zentraleinrichtung
- 21: Recheneinrichtung
- 22: Speicher
- 50: Eisenbahnanlage
- 51: Ortungseinrichtung
- 200: Steuergerät
- 210: Steuergerät

- A1f: erster Anschluss
- A2f: zweiter Anschluss
- A1v: erster Anschluss
- A2v: zweiter Anschluss
- AB1-AB4: Abstandswert
- AK1: erster Anschlusskontakt
- AK2: zweiter Anschlusskontakt
- AP1: erstes Anschlusspaar
- AP2: zweites Anschlusspaar
- AUS1f: erste Auswerteinrichtung
- AUS2f: zweite Auswerteinrichtung
- AUS1v: erste Auswerteinrichtung
- AUS2v: zweite Auswerteinrichtung
- AUS3v: dritte Auswerteinrichtung
- AUS4v: vierte Auswerteinrichtung
- E1f: erste Einspeiseeinrichtung
- E2f: zweite Einspeiseeinrichtung
- E1v: erste Einspeiseeinrichtung
- E2v: zweite Einspeiseeinrichtung
- E3v: dritte Einspeiseeinrichtung
- E4v: vierte Einspeiseeinrichtung
- EP: Erdpotential
- EVN: Energieversorgungsnetz
- F1f: erstes Fehlersignal
- F2f: zweites Fehlersignal
- F1v: erstes Fehlersignal
- F2v: zweites Fehlersignal
- F3v: drittes Fehlersignal
- F4v: viertes Fehlersignal
- FG1: erstes Feldgerät
- FG2: zweites Feldgerät
- FG3: drittes Feldgerät
- FG4: viertes Feldgerät
- L1: erster Phasenleiter
- L2: zweiter Phasenleiter
- L3: dritter Phasenleiter
- M1f: erste Testeinrichtung
- M2f: zweite Testeinrichtung
- M1v: erste Testeinrichtung
- M2v: zweite Testeinrichtung
- M3v: dritte Testeinrichtung
- M4v: vierte Testeinrichtung
- MP: Massepotential
- MS1f: erstes Messsignal
- MS2f: zweites Messsignal
- MS1v: erstes Messsignal
- MS2v: zweites Messsignal
- MS3v: drittes Messsignal
- MS4v: viertes Messsignal
- N: Nullleiter
- OA: Ortsangabe
- R1: Widerstand
- R2: Widerstand
- Rm: hochohmiger Widerstand
- STM: Steuermodul
- T1f: erstes Testspannungssignal
- T2f: zweites Testspannungssignal
- T1v: erstes Testspannungssignal
- T2v: zweites Testspannungssignal
- T3v: drittes Testspannungssignal
- T4v: viertes Testspannungssignal
- TE1: Testeinrichtung erster Art
- TE2: Testeinrichtung zweiter Art
- TE101-TE104: Testeinrichtung zweiter Art
- TE201-TE202: Testeinrichtung erster Art
- U1v: erste Messspannung
- U2v: zweite Messspannung
- U3v: dritte Messspannung
- U4v: vierte Messspannung

## Patentansprüche

1. Testeinrichtung,
**dadurch gekennzeichnet, dass**
die Testeinrichtung (TE1, TE2, TE101-TE104, TE201-TE202) umfasst:
- eine erste Einspeiseeinrichtung (E1v, E1f) zum Anlegen eines ersten kodierten Testsignals (T1v, T1f) zwischen einem ersten Anschluss (A1v, A1f) und einem Referenzanschluss,
- eine erste Messeinrichtung (M1v, M1f), die zum Messen eines ersten Messsignals (MS1v, MS1f) geeignet ist, das durch das erste kodierte Testsignal zumindest mithervorgerufen und von einem etwaigen Erdschluss einer an den ersten Anschluss angeschlossenen Anschlussleitung beeinflusst wird, und
- eine erste Auswerteinrichtung (AUS1v, AUS1f), die das erste Messsignal und das Testsignal einer ersten Korrelationsprüfung unter Bildung eines ersten Korrelationssignals unterwirft und im Falle einer Veränderung der Amplitude des ersten Korrelationssignals über ein vorgegebenes korrelationsbezogenes Maß hinaus auf einen Erdschluss schließt und ein das erste kodierte Testsignal betreffendes erstes Fehlersignal (F1v, F1f) erzeugt.

2. Testeinrichtung nach Anspruch 1,
**dadurch gekennzeichnet, dass**
die Testeinrichtung umfasst:
- eine zweite Einspeiseeinrichtung (E2v, E2f) zum Anlegen eines zweiten kodierten Testsignals (T2v, T2f) zwischen einem zweiten Anschluss (A2v, A2f) und dem Referenzanschluss, wobei das erste und das zweite kodierte Testsignal zueinander orthogonal sind,
- eine zweite Messeinrichtung (M2v, M2f) zum Messen eines zweiten Messsignals (MS2v, MS2f), das durch das zweite kodierte Testsignal zumindest mithervorgerufen wird, und
- eine zweite Auswerteinrichtung (AUS2v, AUS2f), die das zweite Messsignal und das zweite Testsignal einer zweiten Korrelationsprüfung unter Bildung eines zweiten Korrelationssignals unterzieht und im Falle einer Veränderung der Amplitude des zweiten Korrelationssignals über das oder ein anderes vorgegebenes korrelationsbezogenes Maß hinaus auf einen Erdschluss schließt und ein das zweite kodierte Testsignal betreffendes Fehlersignal (F2v, F2f) erzeugt.

3. Testeinrichtung nach Anspruch 2,
**dadurch gekennzeichnet, dass**
die Testeinrichtung umfasst:
- eine oder mehr weitere Einspeiseeinrichtungen (E3v-E4v) zum Anlegen jeweils eines weiteren kodierten Testsignals (T3v-T4v) zwischen einem zugeordneten weiteren Anschluss und dem Referenzanschluss, wobei die kodierten Testspannungssignale zueinander orthogonal sind,
- für jede weitere Einspeiseeinrichtung jeweils eine weitere Messeinrichtung (M3v-M4v) zum Messen jeweils eines weiteren Messsignals (MS3v-MS4v), das durch das jeweilige weitere kodierte Testsignal zumindest mithervorgerufen wird, und
- für jede weitere Einspeiseeinrichtung jeweils eine weitere Auswerteinrichtung (AUS3v-AUS4v), die das jeweilige weitere Messsignal und das jeweilige weitere Testsignal einer weiteren Korrelationsprüfung unter Bildung eines weiteren Korrelationssignals unterzieht und im Falle einer Veränderung der Amplitude des weiteren Korrelationssignals über das oder ein anderes vorgegebenes korrelationsbezogenes Maß hinaus auf einen Erdschluss schließt und ein das weitere kodierte Testsignal betreffendes Fehlersignal erzeugt.

4. Testeinrichtung nach einem der voranstehenden Ansprüche,
**dadurch gekennzeichnet, dass**
die erste Auswerteinrichtung anhand der Amplitude und/oder Phasenlage des jeweiligen Korrelationssignals den Abstand eines Erdschlusses von dem Ort der Testeinrichtung ermittelt.

5. Testeinrichtung nach einem der voranstehenden Ansprüche,
**dadurch gekennzeichnet, dass**
- der Referenzanschluss an das Erdpotential (EP) angeschlossen ist und
- das erste Messsignal ein erster Messstrom ist, der zwischen dem ersten Anschluss und dem Erdpotential fließt, oder eine erste Messspannung ist, die der zwischen dem ersten Anschluss und dem Erdpotential liegenden Spannung entspricht oder proportional zu dieser ist.

6. Steuergerät zum Ansteuern zumindest eines Feldgeräts einer elektrotechnischen Anlage, **dadurch gekennzeichnet, dass**
das Steuergerät mindestens eine Testeinrichtung nach einem der voranstehenden Ansprüche umfasst.

7. Steuergerät nach Anspruch 6,
**dadurch gekennzeichnet, dass**
- das Steuergerät (10) auf einer Feldgeräteseite (12) eine Testeinrichtung nach einem der voranstehenden Ansprüche 1 bis 4 umfasst,
- der erste Anschluss ein erster Anschlusskontakt (AK1) des Steuergeräts zum Übermitteln einer Steuerspannung an ein erstes Feldgerät (FG1) ist und
- der Referenzanschluss mit einem geräteinternen Massepotential (MP) verbunden ist, das an das Erdpotential hochohmig gekoppelt ist.

8. Steuergerät nach Anspruch 7,
**dadurch gekennzeichnet, dass**
- der erste Anschlusskontakt mit einem ersten Anschlusspaar (AP1) verbunden ist und zum Anschluss eines das Steuergerät und das Feldgerät verbindenden ersten Leiters eines ersten Leiterpaares dient,
- das Steuergerät einen zu dem ersten Anschlusspaar gehörenden zweiten Anschlusskontakt (AK2) zum Anschluss eines das Steuergerät und das Feldgerät verbindenden zweiten Leiters des ersten Leiterpaares umfasst,
- das erste kodierte Testsignal zwischen dem ersten Anschlusskontakt und dem Massepotential anliegt und
- das erste Messsignal ein erster Messstrom ist, der zwischen dem zweiten Anschlusskontakt und dem Massepotential fließt, oder eine erste Messspannung ist, die der zwischen dem zweiten Anschlusskontakt und dem Massepotential liegenden Spannung entspricht oder proportional zu dieser ist.

9. Steuergerät nach einem der voranstehenden Ansprüche 6 bis 8,
**dadurch gekennzeichnet, dass**
- das Steuergerät auf einer Energieversorgungsseite (13) eine Testeinrichtung nach Anspruch 5 umfasst und
- der erste Anschluss der Testeinrichtung nach Anspruch 5 ein erster Energieversorgungsanschluss des Feldgeräts zum Anlegen einer ersten externen Energieversorgungsspannung in das Feldgerät ist.

10. Steuergerät nach einem der voranstehenden Ansprüche 6 bis 9,
**dadurch gekennzeichnet, dass**
das Steuergerät ein eisenbahntechnisches Steuergerät zum Steuern einer oder mehr eisenbahntechnischer Feldgeräte, insbesondere einer Weiche oder eines Signals, einer Eisenbahnanlage (50) ist.

11. Eisenbahnanlage (50) mit zumindest einer Testeinrichtung nach einem der voranstehenden Ansprüche 1 bis 5.

12. Eisenbahnanlage (50) nach Anspruch 11,
**dadurch gekennzeichnet, dass**
die Eisenbahnanlage mit zumindest zwei Testeinrichtungen nach einem der voranstehenden Ansprüche 1 bis 5 ausgestattet ist, bei denen
- die ersten Einspeiseeinrichtungen der zumindest zwei Testeinrichtungen jeweils ein erstes kodiertes Testsignal in dieselbe Leitung der Eisenbahnanlage einspeisen,
- die ersten Messeinrichtungen jeweils ein erstes Messsignal messen, das durch ihr jeweiliges erstes kodiertes Testsignal zumindest mithervorgerufen und von einem etwaigen Erdschluss einer an den ersten Anschluss angeschlossenen Leitung beeinflusst wird, und
- die ersten Auswerteinrichtungen jeweils das erste Messsignal ihrer eigenen Testeinrichtung und das Testsignal ihrer eigenen Testeinrichtung einer ersten Korrelationsprüfung unter Bildung eines ersten Korrelationssignals unterwerfen und im Falle einer Veränderung der Amplitude des ersten Korrelationssignals über das vorgegebene korrelationsbezogene Maß hinaus auf einen Erdschluss schließen und ein ihr erstes kodiertes Testsignal betreffendes erstes Fehlersignal erzeugen,
- wobei die ersten kodierten Testspannungssignale der zumindest zwei Testeinrichtungen orthogonal zueinander sind.

13. Eisenbahnanlage (50) nach Anspruch 12,
**dadurch gekennzeichnet, dass**
- den zumindest zwei Testeinrichtungen jeweils die eigene Kodierung zur Bildung des jeweiligen eigenen kodierten ersten Testsignals sowie die Kodierungen, die die anderen Testeinrichtungen zur Bildung der kodierten ersten Testsignale heranziehen, bekannt sind, und
- die ersten Auswerteinrichtungen der zumindest zwei Testeinrichtungen jeweils für jedes Paar an Testeinrichtungen, das die eigene Testeinrichtung und eine beliebige andere der zumindest zwei Testeinrichtungen enthält, jeweils eine erste paarbezogene Kreuzkorrelationsprüfung durchführen,
- wobei sie im Rahmen der Kreuzkorrelationsprüfung jeweils
- mit der bekannten Kodierung der anderen Testeinrichtung des jeweiligen Paares ein erstes Kreuzreferenzmesssignal bilden, das dem von der anderen Testeinrichtung erzeugten ersten Testsignal kodierungsmäßig entspricht, und
- das erste Messsignal ihrer eigenen Testeinrichtung und das jeweilige erste Kreuzreferenzsignal einer ersten Kreuzkorrelationsberechnung unter Bildung eines ersten Kreuzkorrelationssignals unterwerfen,
- wobei sie jeweils im Falle einer Veränderung der Amplitude des ersten Kreuzkorrelationssignals über ein vorgegebenes kreuzkorrelationsbezogenes Maß hinaus auf einen Erdschluss schließen und ein entsprechendes Fehlersignal erzeugen.

14. Eisenbahnanlage nach Anspruch 12 oder 13,
**dadurch gekennzeichnet, dass**
die Eisenbahnanlage eine Ortungseinrichtung (51) umfasst, die anhand von Abstandswerten (AB1-AB4) der Testeinrichtungen den Ort eines Erdschlusses ermittelt.

15. Eisenbahnanlage,
**dadurch gekennzeichnet, dass**
die Eisenbahnanlage mit zumindest einem Steuergerät nach einem der voranstehenden Ansprüche 6 bis 9 ausgestattet ist, das an seiner Feldgeräteseite an zumindest ein Feldgerät der Eisenbahnanlage und an seiner Energieversorgungsseite an ein Energieversorgungsnetz der Eisenbahnanlage angeschlossen ist.

16. Eisenbahnanlage nach Anspruch 15,
**dadurch gekennzeichnet, dass**
das zumindest eine Feldgerät eine Weiche oder ein Eisenbahnsignal ist.
